(19) Europäisches Patentamt
European Patent Office
Office européen des brevets

(11) **EP 3 937 204 A1**

(12) **EUROPEAN PATENT APPLICATION**

(43) Date of publication:
**12.01.2022 Bulletin 2022/02**

(51) Int Cl.:
*H01J 37/04* *(2006.01)*       *H01J 37/073* *(2006.01)*
*H01J 37/075* *(2006.01)*       *H01J 37/244* *(2006.01)*
*H01J 37/28* *(2006.01)*

(21) Application number: **20184160.8**

(22) Date of filing: **06.07.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventor: **WIELAND, Marco, Jan-Jaco**
**5500 AH Veldhoven (NL)**

(74) Representative: **ASML Netherlands B.V.**
**Corporate Intellectual Property**
**P.O. Box 324**
**5500 AH Veldhoven (NL)**

(54) **INSPECTION APPARATUS**

(57)    A charged particle assessment tool comprising: an objective lens configured to project a plurality of charged particle beams onto a sample, the objective lens having an sample-facing surface defining a plurality of beam apertures through which respective ones of the charged particle beams are emitted toward the sample; and a plurality of capture electrodes adjacent respective ones of the beam apertures and configured to capture charged particles emitted from the sample.

# Fig. 4

**Description**

<u>FIELD</u>

The embodiments provided herein generally relate to a charged particle inspection apparatus, and more particularly, a charged particle beam inspection apparatus using more than one beam of charged particles.

<u>BACKGROUND</u>

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface, a pattern inspection tool may obtain an image representing characteristics of the material structure of the surface of the sample.

There is a general need to improve the throughput and other characteristics of a charged particle inspection apparatus.

SUMMARY

The embodiments provided herein disclose a charged particle beam inspection apparatus.

According to a first aspect of the invention, there is provided a charged particle assessment tool comprising:

an objective lens configured to project a plurality of charged particle beams onto a sample, the objective lens defining a plurality of beam apertures through which respective ones of the charged particle beams can propagate toward the sample; and
a plurality of sensor units adjacent respective ones of the beam apertures and configured to capture charged particles emitted from the sample.

According to a second aspect of the invention, there is provided a method of manufacturing an assessment tool, the method comprising:

forming a plurality of sensor units on, and a plurality of apertures in, a substrate; and
attaching the substrate to an objective lens configured to project a plurality of charged particle beams onto a sample, so that the charged particle beams can be emitted through the apertures.

According to a third aspect of the invention, there is provided an inspection method comprising:

emitting a plurality of charged-particle beams through a plurality of beam apertures to a sample; and
capturing charged particles emitted by the sample in response to the charged-particle beams using a plurality of sensor units provided adjacent respective ones of the beam apertures.

According to a fourth aspect of the invention, there is provided a multi-beam electron-optical system comprising a last electron-optical element in a multi-beam path of the multi-beam electron optical system, the last electron-optical element comprising

- a multi-manipulator array in which each array element is configured to manipulate at least one electron beam in the multi-beam path; and
- a detector configured and orientated to detect electrons emitted from a sample positioned in the multi-beam beam path, wherein the detector comprises a plurality of sensor units integrated into the multi-manipulator array and at least one sensor unit associated each array element.

According to a fourth aspect of the invention, there is provided a last electron-optical element for a multi-charged beam projection system configured to project a plurality of charged particle beams onto a sample, the last electron-optical element comprising:

an objective lens having an sample-facing surface defining a plurality of beam apertures through which respective ones of the charged particle beams can propagate toward the sample; and
a plurality of sensor units adjacent respective ones of the beam apertures and configured to capture charged particles emitted from the sample.

Other advantages of the present invention will become apparent from the following description taken in conjunction with the accompanying drawings wherein are set forth, by way of illustration and example, certain embodiments of the present invention.

BRIEF DESCRIPTION OF FIGURES

The above and other aspects of the present disclosure will become more apparent from the description of exemplary embodiments, taken in conjunction with the accompanying drawings.

FIG. 1 is a schematic diagram illustrating an exemplary charged particle beam inspection apparatus.
FIG. 2 is a schematic diagram illustrating an exemplary multi-beam apparatus that is part of the exemplary charged particle beam inspection apparatus of **FIG. 1**.
FIG. 3 is a schematic diagram of exemplary multi-beam apparatus illustrating an exemplary configuration of source conversion unit of the exemplary charged particle beam inspection apparatus of **FIG. 1**.
FIG. 4 is a schematic cross-sectional view of an objective lens of an inspection apparatus according to an embodiment.
FIG. 5 is a bottom view of the objective lens of **FIG. 4**.
FIG. 6 is a bottom view of a modification of the objective lens of **FIG. 4**.
FIG. 7 is an enlarged schematic cross-sectional view of a detector incorporated in the objective lens of **FIG. 4**.
FIG. 8 is a schematic diagram of a theoretical trans impedance amplifier.
FIG. 9 is a schematic diagram of a trans impedance amplifier indicating the effect of thermal noise.
FIG. 10 is a schematic diagram illustrating another exemplary multi-beam apparatus that may be part of the exemplary charged particle beam inspection apparatus of **FIG. 1**.
FIG. 11 is a schematic diagram illustrating another exemplary multi-beam apparatus according to an embodiment.
FIG. 12 is a schematic diagram of exemplary multi-beam apparatus according to an embodiment.
FIG. 13 is a schematic cross-sectional view of an objective lens of an inspection apparatus according to an embodiment.
FIG. 14 is a bottom view of a detector unit incorporated in the objective lens of **FIG. 13**.

DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%,. If an individual step has a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises an scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

In a multi-beam inspection apparatus, the paths of some of the primary electron beams are displaced away from the central axis, i.e. a mid-point of the primary electron optical axis, of the scanning device. To ensure all the electron beams arrive at the sample surface with substantially the same angle of incidence, sub-beam paths with a greater radial distance from the central axis need to be manipulated to move through a greater angle than the sub-beam paths with paths closer to the central axis. This stronger manipulation may cause aberrations which result in blurry and out-of-focus images of the sample substrate. In particular, for sub-beam paths that are not on the central axis, the aberrations in the sub-beams may increase with the radial displacement from the central axis. Such aberrations may remain associated with the secondary electrons when they are detected. Such aberrations therefore degrade the quality of images that are created during inspection.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

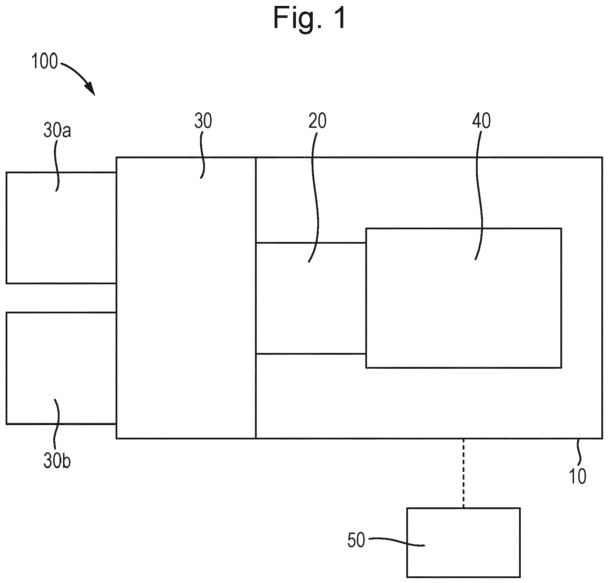

Reference is now made to **FIG. 1,** which is a schematic diagram illustrating an exemplary charged particle beam inspection apparatus 100. The charged particle beam inspection apparatus 100 of **FIG. 1** includes a main chamber 10, a load lock chamber 20, an electron beam tool 40, an equipment front end module (EFEM) 30 and a controller 50. Electron beam tool 40 is located within main chamber 10.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure in around the sample reaches a second pressure lower than the first pressure. After reaching the second pressure, the sample is transported to the electron beam tool by which it may be inspected. An electron beam tool 40 may comprise a multi-beam electron-optical apparatus.

Controller 50 is electronically connected to electron beam tool 40. Controller 50 may be a processor (such as a computer) configured to control the charged particle beam inspection apparatus 100. Controller 50 may also include a processing circuitry configured to execute various signal and image processing functions. While controller 50 is shown in **FIG. 1** as being outside of the structure that includes main chamber 10, load lock chamber 20, and EFEM 30, it is appreciated that controller 50 may be part of the structure. The controller 50 may be located in one of the component elements of the charged particle beam inspection apparatus or it can be distributed over at least two of the component elements. While the present disclosure provides examples of main chamber 10 housing an electron beam inspection tool, it should be noted that aspects of the disclosure in their broadest sense are not limited to a chamber housing an electron beam inspection tool. Rather, it is appreciated that the foregoing principles may also be applied to other tools and other arrangements of apparatus, that operate under the second pressure.

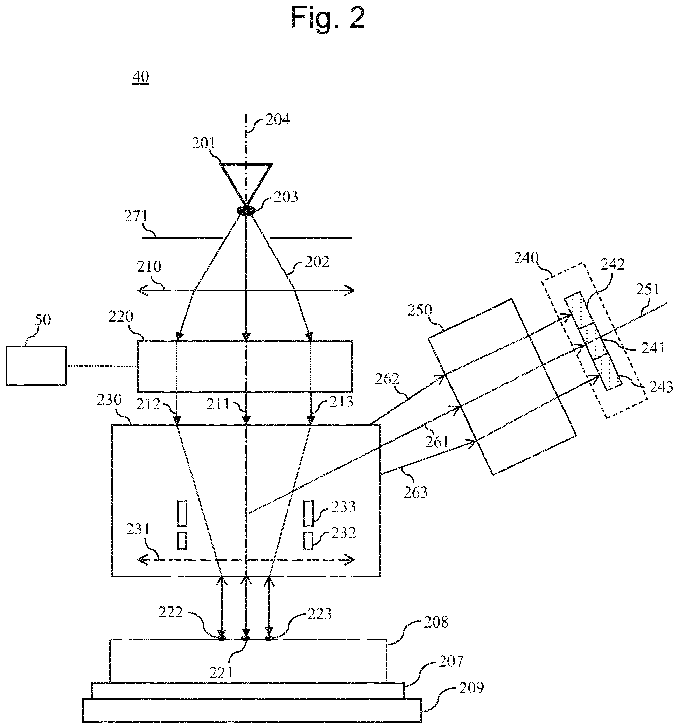

Reference is now made to **FIG. 2,** which is a schematic diagram illustrating an exemplary electron beam tool 40 including a multi-beam inspection tool that is part of the exemplary charged particle beam inspection apparatus 100 of **FIG. 1.** Multi-beam electron beam tool 40 (also referred to herein as apparatus 40) comprises an electron source 201, a gun aperture plate 271, a condenser lens 210, a source conversion unit 220, a primary projection apparatus 230, a motorized stage 209, and a sample holder 207. The electron source 201, a gun aperture plate 271, a condenser lens 210, a source conversion unit 220 are the components of an illumination apparatus comprised by the multi-beam electron beam tool 40. The sample holder 207 is supported by motorized stage 209 so as to hold a sample 208 (e.g., a substrate or a mask) for inspection. Multi-beam electron beam tool 40 may further comprise a secondary projection apparatus 250 and an associated electron detection device 240. Primary projection apparatus 230 may comprise an objective lens 231, e.g. a unitary lens operating on the whole beam. An objective lens may be the last electron-optical element in the path of the multi-beam or in the electron-optical system; so the objective lens may be referred to as a type of last electron-optical element. Electron detection device 240 may comprise a plurality of detection elements 241, 242, and 243. A beam separator 233 and a deflection scanning unit 232 may be positioned inside primary projection apparatus 230.

The components that are used to generate a primary beam may be aligned with a primary electron-optical axis of the apparatus 40. These components can include: the electron source 201, gun aperture plate 271, condenser lens 210, source conversion unit 220, beam separator 233, deflection scanning unit 232, and primary projection apparatus 230. Secondary projection apparatus 250 and its associated electron detection device 240 may be aligned with a secondary electron-optical axis 251 of apparatus 40.

The primary electron-optical axis 204 is comprised by the electron-optical axis of the of the part of electron beam tool 40 that is the illumination apparatus. The secondary electron-optical axis 251 is the electron-optical axis of the of the part of electron beam tool 40 that is a detection apparatus. The primary electron-optical axis 204 may also be referred to herein as the primary optical axis (to aid ease of reference) or charged particle optical axis. The secondary electron-optical axis 251 may also be referred to herein as the secondary optical axis or the secondary charged particle optical axis.

Electron source 201 may comprise a cathode (not shown) and an extractor or anode (not shown). During operation, electron source 201 is configured to emit electrons as primary electrons from the cathode. The primary electrons are extracted or accelerated by the extractor and/or the anode to form a primary electron beam 202 that forms a primary beam crossover (virtual or real) 203. Primary electron beam 202 may be visualized as being emitted from primary beam crossover 203.

In this arrangement a primary electron beam, by the time it reaches the sample, and preferably before it reaches the projection apparatus, is a multi-beam. Such a multi-beam can be generated from the primary electron beam in a number of different ways. For example, the multi-beam may be generated by a multi-beam array located before the cross-over, a multi-beam array located in the source conversion unit 220, or a multi-beam array located at any point in between these locations. A multi-beam array may comprise a plurality of electron beam manipulating elements arranged in an array across the beam path. Each manipulating element may influence the primary electron beam to generate a sub-beam. Thus the multi-beam array interacts with an incident primary beam path to generate a multi-beam path down-beam of the multi-beam array.

Gun aperture plate 271, in operation, is configured to block off peripheral electrons of primary electron beam 202 to reduce Coulomb effect. The Coulomb effect may enlarge the size of each of probe spots 221, 222, and 223 of primary sub-beams 211, 212, 213, and therefore deteriorate inspection resolution. A gun aperture plate 271 may also be referred to as a coulomb aperture array.

Condenser lens 210 is configured to focus primary electron beam 202. Condenser lens 210 may be designed to focus primary electron beam 202 to become a parallel beam and be normally incident onto source conversion unit 220. Condenser lens 210 may be a movable condenser lens that may be configured so that the position of its first principle plane is movable. The movable condenser lens may be configured to be magnetic. Condenser lens 210 may be an anti-rotation condenser lens and/or it may be movable.

Source conversion unit 220 may comprise an image-forming element array, an aberration compensator array, a beam-limit aperture array, and a pre-bending micro-deflector array. The pre-bending micro-deflector array may deflect a plurality of primary sub-beams 211, 212, 213 of primary electron beam 202 to normally enter the beam-limit aperture array, the image-forming element array, and an aberration compensator array. In this arrangement, the image-forming element array may function as a multi-beam array to generate the plurality of sub-beams in the multi-beam path, i.e. primary sub-beams 211, 212, 213. The image forming array may comprise a plurality electron beam manipulators such as micro-deflectors or micro-lenses (or a combination of both) to influence the plurality of primary sub-beams 211, 212, 213 of primary electron beam 202 and to form a plurality of parallel images (virtual or real) of primary beam crossover 203, one for each of the primary sub-beams 211, 212, and 213. The aberration compensator array may comprise a field curvature compensator array (not shown) and an astigmatism compensator array (not shown). The field curvature compensator array may comprise a plurality of micro-lenses to compensate field curvature aberrations of the primary sub-beams 211, 212, and 213. The astigmatism compensator array may comprise a plurality of micro-stigmators to compensate astigmatism aberrations of the primary sub-beams 211, 212, and 213. The beam-limit aperture array may be configured to limit diameters of individual primary sub-beams 211, 212, and 213. **FIG. 2** shows three primary sub-beams 211, 212, and 213 as an example, and it should be understood that source conversion unit 220 may be configured to form any number of primary sub-beams. Controller 50 may be connected to various parts of charged particle beam inspection apparatus 100 of **FIG. 1,** such as source conversion unit 220, electron detection device 240, primary projection apparatus 230, or motorized stage 209. As explained in further detail below, controller 50 may perform various image and signal processing functions. Controller 50 may also generate various control signals to govern operations of the charged particle beam inspection apparatus, including the charged particle multi-beam apparatus.

Condenser lens 210 may further be configured to adjust electric currents of primary sub-beams 211, 212, 213 down-beam of source conversion unit 220 by varying the focusing power of condenser lens 210. Alternatively, or additionally, the electric currents of the primary sub-beams 211, 212, 213 may be changed by altering the radial sizes of beam-limit apertures within the beam-limit aperture array corresponding to the individual primary sub-beams. The electric currents may be changed by both altering the radial sizes of beam-limit apertures and the focusing power of condenser lens 210. If the condenser lens is moveable and magnetic, off-axis sub-beams 212 and 213 may result that illuminate source conversion unit 220 with rotation angles. The rotation angles change with the focusing power or the position of the first principal plane of the movable condenser lens. A condenser lens 210 that is an anti-rotation condenser lens may be configured to keep the rotation angles unchanged while the focusing power of condenser lens 210 is changed. Such a condenser lens 210 that is also movable, may cause the rotation angles not change when the focusing power of the condenser lens 210 and the position of its first principal plane are varied.

Objective lens 231 may be configured to focus sub-beams 211, 212, and 213 onto a sample 208 for inspection and may form three probe spots 221, 222, and 223 on the surface of sample 208.

Beam separator 233 may be, for example, a Wien filter comprising an electrostatic deflector generating an electrostatic dipole field and a magnetic dipole field (not shown in **FIG. 2**). In operation, beam separator 233 may be configured to exert an electrostatic force by electrostatic dipole field on individual electrons of primary sub-beams 211, 212, and 213. The electrostatic force is equal in magnitude but opposite in direction to the magnetic force exerted by magnetic dipole field of beam separator 233 on the individual electrons. Primary sub-beams 211, 212, and 213 may therefore pass at least substantially straight through beam separator 233 with at least substantially zero deflection angles.

Deflection scanning unit 232, in operation, is configured to deflect primary sub-beams 211, 212, and 213 to scan probe spots 221, 222, and 223 across individual scanning areas in a section of the surface of sample 208. In response to incidence of primary sub-beams 211, 212, and 213 or probe spots 221, 222, and 223 on sample 208, electrons are generated from the sample 208 which include secondary electrons and backscattered electrons. The secondary electrons propagate in three secondary electron beams 261, 262, and 263. The secondary electron beams 261, 262, and 263 typically have secondary electrons (having electron energy $\leq$ 50eV) and may also have at least some of the backscattered electrons (having electron energy between 50eV and the landing energy of primary sub-beams 211, 212, and 213). The beam separator 233 is arranged to deflect the path of the secondary electron beams 261, 262, and 263 towards the secondary projection apparatus 250. The secondary projection apparatus 250 subsequently focuses the path of secondary electron beams 261, 262, and 263 onto a plurality of detection regions 241, 242, and 243 of electron detection device 240. The detection regions may be the separate detection elements 241, 242, and 243 that are arranged to detect corresponding secondary electron beams 261, 262, and 263. The detection regions generate corresponding signals which are sent to controller 50 or a signal processing system (not shown), e.g. to construct images of the corresponding scanned areas of sample 208.

The detection elements 241, 242, and 243 may detect the corresponding secondary electron beams 261, 262, and 263. On incidence of secondary electron beams with the detection elements 241, 242 and 243, the elements may generate corresponding intensity signal outputs (not shown). The outputs may be directed to an image processing system (e.g., controller 50). Each detection element 241, 242, and 243 may comprise one or more pixels. The intensity signal output of a detection element may be a sum of signals generated by all the pixels within the detection element.

The controller 50 may comprise image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to an electron detection device 240 of the apparatus 40 permitting signal communication, such as an electrical conductor, optical fiber cable, portable storage media, IR, Bluetooth, internet, wireless network, wireless radio, among others, or a combination thereof. The image acquirer may receive a signal from electron detection device 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample based on an imaging signal received from the electron detection device 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of sample 208. The reconstructed images can thereby be used to reveal any defects that may exist in the sample.

The controller 50 may control motorized stage 209 to move sample 208 during inspection of sample 208. The controller 50 may enable motorized stage 209 to move sample 208 in a direction, preferably continuously, for example at a constant speed, at least during sample inspection. The controller 50 may control movement of the motorized stage 209 so that it changes the speed of the movement of the sample 208 dependent on various parameters. For example, the controller may control the stage speed (including its direction) depending on the characteristics of the inspection steps of scanning process.

Although **FIG. 2** shows that apparatus 40 uses three primary electron sub-beams, it is appreciated that apparatus 40 may use two or more number of primary electron sub-beams. The present disclosure does not limit the number of primary electron beams used in apparatus 40.

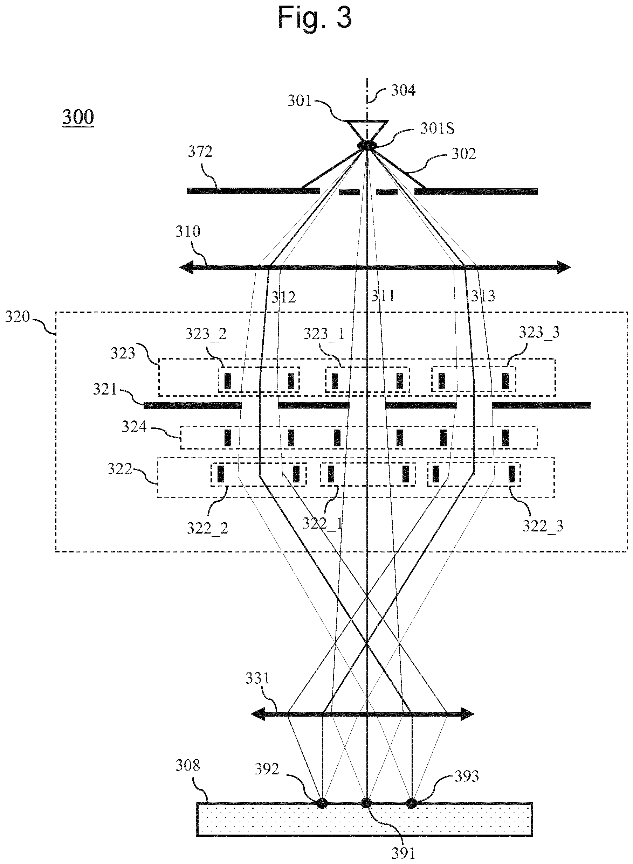

Reference is now made to **FIG. 3,** which is a schematic diagram of exemplary multi-beam apparatus illustrating an exemplary configuration of source conversion unit of the exemplary charged particle beam inspection apparatus of **FIG. 1.** The apparatus 300 may comprise an election source 301, a pre-sub-beam-forming aperture array 372, a condenser lens 310 (similar to condenser lens 210 of **FIG. 2**), a source conversion unit 320, an objective lens 331 (similar to objective lens 231 of **FIG. 2**), and a sample 308 (similar to sample 208 of **FIG. 2**). The election source 301, a pre-sub-beam-forming aperture array 372, a condenser lens 310 may be the components of an illumination apparatus comprised by the apparatus 300. The source conversion unit 320, an objective lens 331 may the components of a projection apparatus comprised by the apparatus 300. The source conversion unit 320 may be similar to source conversion unit 220 of **FIG. 2** in which the image-forming element array of **FIG. 2** is image-forming element array 322, the aberration compensator array of **FIG. 2** is aberration compensator array 324, the beam-limit aperture array of **FIG. 2** is beam-limit aperture array 321, and the pre-bending micro-deflector array of **FIG. 2** is pre-bending micro-deflector array 323. The election source 301, the pre-sub-beam-forming aperture array 372, the condenser lens 310, the source conversion unit 320, and the objective lens 331 are aligned with a primary electron-optical axis 304 of the apparatus. The electron source 301 generates a primary-electron beam 302 generally along the primary electron-optical axis 304 and with a source crossover (virtual or real) 301S. The pre-sub-beam-forming aperture array 372 cuts the peripheral electrons of primary electron beam 302 to reduce a consequential Coulomb effect. The Coulomb effect is a source of aberration to the sub-beams due to interaction between electrons in different sub-beam paths. Primary-electron beam 302 may be trimmed into a specified number of sub-beams, such as three sub-beams 311, 312 and 313, by pre-sub-beam-forming aperture array 372 of a pre-sub-beam-forming mechanism. Although three sub-beams and their paths are referred to in the previous and following description, it should be understood that the description is intended to apply an apparatus, tool, or system with any number of sub-beams.

The source conversion unit 320 may include a sub-beam-limit aperture array 321 with beam-limit apertures configured to limit the sub-beams 311, 312, and 313 of the primary electron beam 302. The source conversion unit 320 may also include an image-forming element array 322 with image-forming micro-deflectors, 322_1, 322_2, and 322_3. There is a respective micro-deflector associated with the path of each sub-beam. The micro-deflectors 322_1, 322_2, and 322_3 are configured to deflect the paths of the sub-beams 311, 312, and 313 towards the electron-optical axis 304. The deflected sub-beams 311, 312 and 313 form virtual images of source crossover 301S. The virtual images are projected onto the sample 308 by the objective lens 331 and form probe spots thereon, which are the three probe spots, 391, 392, and 393. Each probe spot corresponds to the location of incidence of a sub-beam path on the sample surface. The source conversion unit 320 may further comprise an aberration compensator array 324 configured to compensate aberrations of each of the sub-beams. The aberrations in each sub-beam are typically present on the probe spots, 391, 392, and 393 that would be formed a sample surface. The aberration compensator array 324 may include a field curvature compensator array (not shown) with micro-lenses. The field curvature compensator and micro-lenses are configured to compensate the sub-beams for field curvature aberrations evident in the probe spots, 391, 392, and 393. The aberration compensator array 324 may include an astigmatism compensator array (not shown) with micro-stigmators. The micro-stigmators are controlled to operate on the sub-beams to compensate astigmatism aberrations that are otherwise present in the probe spots, 391, 392, and 393.

The source conversion unit 320 may further comprise a pre-bending micro-deflector array 323 with pre-bending micro-deflectors 323_1, 323_2, and 323_3 to bend the sub-beams 311, 312, and 313 respectively. The pre-bending micro-deflectors 323_1, 323_2, and 323_3 may bend the path of the sub-beams onto the beamlet-limit aperture array 321. The sub-beam path of the incident on beamlet-limit aperture array 321 may be orthogonal to the plane of orientation of the beamlet-limit aperture array 321. The condenser lens 310 may direct the path of the sub-beams onto the beamlet-limit aperture array 321. The condenser lens 310 may focus the three sub-beams 311, 312, and 313 to become parallel beams along primary electron-optical axis 304, so that it is perpendicularly incident onto source conversion unit 320, which may correspond to the beamlet-limit aperture array 321.

The image-forming element array 322, the aberration compensator array 324, and the pre-bending micro-deflector array 323 may comprise multiple layers of sub-beam manipulating devices, some of which may be in the form or arrays, for example: micro-deflectors, micro-lenses, or micro-stigmators.

In source the conversion unit 320, the sub-beams 311, 312 and 313 of the primary electron beam 302 are respectively deflected by the micro-deflectors 322_1, 322_2 and 322_3 of image-forming element array 322 towards the primary electron-optical axis 304. It should be understood that the sub-beam 311 path may already correspond to the electron-optical axis 304 prior to reaching micro-deflector 322_1, accordingly the sub-beam 311 path may not be deflected by micro-deflector 322_1.

The objective lens 331 focuses the sub-beams onto the surface of the sample 308, i.e., it projects the three virtual images onto the sample surface. The three images formed by three sub-beams 311 to 313 on the sample surface form three probe spots 391, 392 and 393 thereon. The deflection angles of sub-beams 311 to 313 are adj usted by the obj ective lens 311 to reduce the off-axis aberrations of three probe spots 391-393. The three deflected sub-beams consequently pass through or approach the front focal point of objective lens 331. As depicted the objective lens 331 is a magnetic lens that focuses all of the sub-beams. In an embodiment of the invention the objective lens is desirably an array of electrostatic lenses which may require the multibeam path to be directed by the source conversion unit 320, specifically for example the image-forming element array 322 featuring micro-deflectors, towards the array of electrostatic lenses in the objective lens 331. (For example each beam could be directed towards its own corresponding micro-lens in the array).

At least some of the above-described components in **FIG. 2** and **FIG. 3** may individually, or in combination with each other, be referred to as a manipulator array, multi-manipulator array, multi-manipulator or manipulator, because they manipulate one or more beams, or sub-beams, of charged particles.

Existing multi-e-beam defect inspection systems have resolution of about 2 to 10 nm at a throughput of 10 to 6000 mm$^2$ per hour. Such systems have a detector in a secondary column as discussed above. The architecture of existing multi-e-beam inspection tools has a detector remote from the source of electrons emitted from the sample such as back scattered and secondary electrons, which is not scalable for a many-beam system. It is also difficult to integrate a secondary column into a tool with an array objective lens, such as an electrostatic lens, (which is necessary to address coulomb interactions).

In an embodiment the objective lens referred to in earlier embodiments is an array objective lens. Typically such a lens arrangement is electrostatic. Each element in the array is a micro-lens operating a different beam or group of beams in the multi-beam. An electrostatic array objective lens has at least two plates each with a plurality of holes or apertures. The position of each hole in a plate corresponds to the position of a corresponding hole in the other plate. The corresponding holes operate in use on the same beam or group of beams in the multi-beam. A suitable example of a type of lens for each element in the array is an Einzel lens. The bottom electrode of objective lens is a CMOS chip detector integrated into a multi-beam manipulator array. Integration of a detector array into the objective lens removes the need for the secondary projection apparatus 250. The CMOS chip is preferably orientated to face a sample (because of the small distance (e.g. 100$\mu$m) between wafer and bottom of the electron-optical system). In an embodiment, capture electrodes to capture the secondary electron signals are provided. The capture electrodes can be formed in the metal layer of, for example, a CMOS device. The capture electrode may form the bottom layer of the objective lens. The capture electrode may form the bottom surface in a CMOS chip. The CMOS chip may be a CMOS chip detector. The CMOS chip may be integrated into the sample facing surface of an objective lens assembly. The capture electrodes are examples of sensor units for detecting secondary electrons. The capture electrodes can be formed in other layers. Power and control signals of the CMOS may be connected to the CMOS by through-silicon vias. For robustness, preferably the bottom electrode consist of two elements: the CMOS chip and a passive Si plate with holes. The plate shields the CMOS from high E-fields.

Sensor units associated with bottom or sample facing surface of an objective lens are beneficial because the secondary and/or back-scatted electrons may be detected before the electrons encounter and become manipulated by an electron optical element of the electron-optical system. Beneficially the time taken for detection of such a sample emanating electron may be reduced preferably minimized.

In order to maximize the detection efficiency it is desirable to make the electrode surface as large as possible, so that substantially all the area of the array objective lens (excepting the apertures) is occupied by electrodes and each electrode has a diameter substantially equal to the array pitch. In an embodiment the outer shape of the electrode is a circle, but this can be made a square to maximize the detection area. Also the diameter of the through-substrate hole can be minimized. Typical size of the electron beam is in the order of 5 to 15 micron.

In an embodiment, a single capture electrode surrounds each aperture. In another embodiment, a plurality of electrode elements is provided around each aperture. The electrode elements are examples of sensor elements. The electrons captured by the electrode elements surrounding one aperture may be combined into a single signal or used to generate independent signals. The electrode elements may be divided radially (i.e. to form a plurality of concentric annuluses), angularly (i.e. to form a plurality of sector-like pieces), both radially and angularly or in any other convenient manner.

However a larger electrode surface leads to a larger parasitic capacitance, so a lower bandwidth. For this reason it may be desirable to limit the outer diameter of the electrode. Especially in case a larger electrode gives only a slightly larger detection efficiency, but a significantly larger capacitance. A circular (annular) electrode may provide a good compromise between collection efficiency and parasitic capacitance.

A larger outer diameter of the electrode may also lead to a larger crosstalk (sensitivity to the signal of a neighboring hole). This can also be a reason to make the electrode outer diameter smaller. Especially in case a larger electrode gives only a slightly larger detection efficiency, but a significantly larger crosstalk.

The back-scattered and/or secondary electron current collected by electrode is amplified . The purpose of the amplifier is to enable sufficiently sensitive measurement of the current received or collected by the sensor unit to be measured and thus the number of back-scattered and/or secondary electrons. This can be measured by current measurements or the potential difference over a resistor. Several types of amplifier design may be used to amplify back-scattered and/or secondary electron current collected by electrode for example a Trans Impedance Amplifier. In such a Trans-Impedance Amplifier, the voltage output of the TIA is equal to the TIA resistance ($R_{TIA}$) multiplied by the measured current.

The larger $R_{TIA}$, the higher the amplification. However the bandwidth is determined by the RC time, which is equal to $R_{TIA}$ multiplied by the sum of the capacitances on the entrance side of the TIA.

A finite RC time has a similar effect as a larger electron optics spotsize, so it gives effectively a blur contribution in the deflection direction. Given the blur contribution budget of the detector and the deflection velocity the allowed RC time is determined. Given this RC time and the entrance capacitances $R_{TIA}$ is determined.

Based on the back-scattered and/or secondary electron current and $R_{TIA}$ the signal voltage is determined.

Noise contributions of the detector should be compared to the shot noise of the back-scattered and/or secondary electron current. Taking only the shot noise of the primary electron beam into account, the current noise per sqrt(Hz) due to shot noise is significantly larger than the voltage noise of a state of the art CMOS amplifier of typically ~1nV/sqrt(Hz) as demonstrated below. The rough calculations set out below demonstrate that the proposed electrode is feasible from a noise point of view.

$$N_{PE\_def} = 5000 \tag{1}$$

$$I_{beam} = 1\,nA \tag{2}$$

$$d_{def} = 4\,nm \tag{3}$$

$$N_{pix\_defect} = 4 \tag{4}$$

$$blur_{rc} = 0.5\,nm \tag{5}$$

$$C_{detector} = \varepsilon_0.\zeta.\frac{0.25.\pi.(100\,\mu m)^2}{1\,\mu m} = 2.086 \times 10^{-13}F \tag{6}$$

$$I_{sn\_noise} = \sqrt{2.Q_e.I_{beam}} = 1.79 \times 10^{-14}\frac{A}{\sqrt{Hz}} \tag{7}$$

$$t_{defect} = \frac{N_{PE\_def}.Q_e}{I_{beam}} = 0.801\,\mu s \tag{8}$$

$$1_{scan\_defect} := d_{def}\sqrt{N_{pix_{defect}}} = 8\,nm \tag{9}$$

$$v_{scan} = \frac{1_{scan\_defect}}{t_{defect}} = 9.986\,\frac{mm}{s} \tag{10}$$

$$t_{RC} = \frac{blur_{RC}}{v_{scan}} = 50.069\,ns \tag{11}$$

$$R_{detector} = \frac{t_{RC}}{C_{detector}} = 2.4\,x\,10^5\,\Omega \tag{12}$$

$$V_{sn} = I_{sn\_noise}\,R_{detector} = 4.296\,\frac{nV}{\sqrt{Hz}} \tag{13}$$

$$V_{sn} = \frac{\sqrt{2}\,Q_e^{3/2}}{\sqrt{I_{beam}}}\frac{blur_{RC}\,N_{PE\_def}}{C_{detector}d_{def}\sqrt{N_{pix\_defect}}} = 4.296\,\frac{nV}{\sqrt{Hz}} \tag{14}$$

The above calculations can be explained as follows. It is assumed that the number of primary electrons required to detected a defect is 5000 (equation 1), the beam current is 1 nA (equation 2) the diameter of a defect is 4 nm (equation 3) and the number of pixels per defect is 4 (equation 4). We assume that a blur due to the finite RC time of the amplifier of 0.5 nm is acceptable (equation 5). The capacitance of the detector can be calculated from the geometry of the arrangement, for example, as indicated in equation 6 where 3 is the dielectric constant of the insulator underlying the capture electrode, 100 $\mu$m is the diameter of the capture electrode and 1 $\mu$m is the thickness of the insulator underneath the capture electrode. The intrinsic shot noise is calculated as in equation 7. The time to image one defect is calculated as in equation 8 where $Q_e$ is the electron charge. The length of a scan to detect a defect is calculated in equation 9 and the scanning velocity is calculated in equation 10. The RC time to be achieved is calculated in equation 11 and therefore the resistance of the detector is calculated in equation 12 and the resulting voltage noise in equation 13. Equation 14 combines the previous equations into a single equation to show dependencies. The typical voltage noise level that can be achieved in CMOS amplifiers is in the order of 1nV/sqrt(Hz) - which this typical noise level of a CMOS amplifier. So it is plausible that the noise is dominated by the fundamental shot noise, and not by the voltage noise added by the CMOS amplifier. Because of this it is plausible that the proposed electrode is feasible from a noise point of view. That is a typical CMOS amplifier noise is sufficiently good to have a noise level that is small relative to the shot noise. (Even if it is large relative the shot noise, the arrangement could still work, but the effectiveness in terms of bandwidth or throughput (i.e. speed) could be reduced).

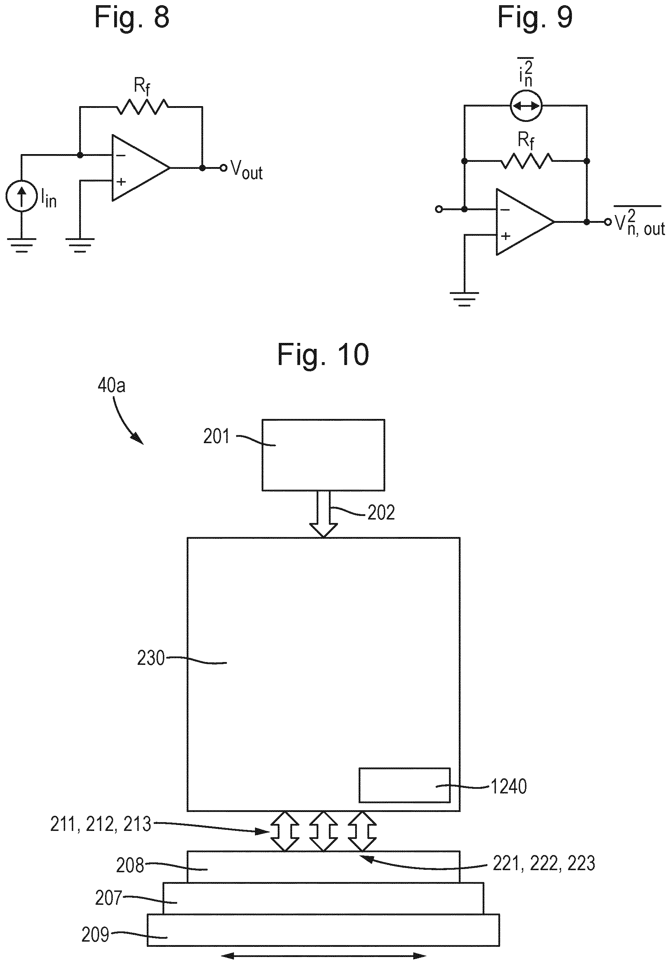

Figure 8 is a schematic diagram of a theoretical trans impedance amplifier (TIA) in which the voltage output $V_{out}$ is simply the product of the measured current $I_{in}$ and the feedback resistance $R_f$. However, a real TIA has noise, in particular shot noise in the input $i_{sn}$ and thermal noise in the feedback resistor $i_n$ as depicted in Figure 9. In most cases thermal noise dominates. The voltage noise at the output $v_n$ is given by:

$$v_n = \sqrt{4.k_b.T.R_f} \tag{15}$$

where $k_b$ is the Boltzmann constant. The current noise at the entrance to the TIA is therefore:

$$i_n = \sqrt{\frac{4.k_b.T}{R_f}} \qquad (16)$$

whereas the shot noise is given by:

$$i_{sn} = \sqrt{2.Q_e.I_{in}} \qquad (17)$$

Therefore if the feedback resistance is increased, the thermal noise becomes lower relative to the shot noise of the input current (i.e. the back-scattered and/or secondary electron current).

It can be shown that the invention remains practical taking account of the effect of shot noise, by assuming that the number of electrons required to detect each defect is increased to 10,000; a blur budget of 2 nm is set; and the electrode diameter is reduced to 50 μm. In that case, the capacitance of the electrode becomes about 0.011 pF requiring a resistance of about 3.6 x 10$^7$ Ω, resulting in a level of thermal noise about 20% greater than the shot noise. Therefore, various different arrangements of the proposed detector are feasible. The capacitance of the electrode can also be controlled by varying the thickness of an adjacent dielectric layer, which may be in the range of about 1 to about 5 μm.

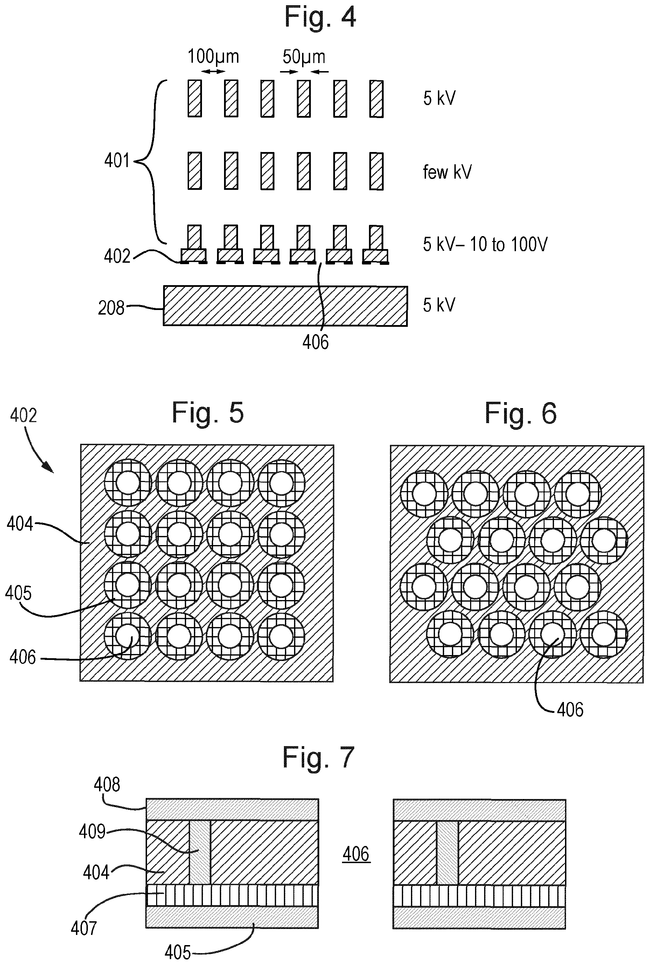

An exemplary embodiment is shown in **FIG. 4** which illustrates a multibeam objective lens 401 in schematic cross section. On the output side of the objective lens 401, the side facing the sample 208, a detector module 402 is provided. **FIG. 5** is a bottom view of detector module 402 which comprises a substrate 404 on which are provided a plurality of capture electrodes 405 each surrounding a beam aperture 406. Beam apertures 406 are large enough not to block any of the primary electron beams. Capture electrodes 405 can be considered as examples of sensor units which receive back-scattered or secondary electrodes and generate a detection signal, in this case an electric current. The beam apertures 406 may be formed by etching through substrate 404. In the arrangement shown in **FIG. 5,** the beam apertures 406 are shown in a rectangular array. The beam apertures 406 can also be differently arranged, e.g. in a hexagonal close packed array as depicted in **FIG. 6.**

**FIG. 7** depicts at a larger scale a part of the detector module 402 in cross section. Capture electrodes 405 form the bottommost, i.e. most close to the sample, surface of the detector module 402. Between the capture electrodes 405 and the main body of the silicon substrate 404 a logic layer 407 is provided. Logic layer 407 may include amplifiers, e.g. Trans Impedance Amplifiers, analogue to digital converters, and readout logic. In an embodiment, there is one amplifier and one analogue to digital converter per capture electrode 405. Logic layer 407 and capture electrodes 405 can be manufactured using a CMOS process with the capture electrodes 405 forming the final metallisation layer.

A wiring layer 408 is provided on the backside of substrate 404 and connected to the logic layer 407 by through-silicon vias 409. The number of through-silicon vias 409 need not be the same as the number of beam apertures 406. In particular if the electrode signals are digitized in the logic layer 407 only a small number of through-silicon vias may be required to provide a data bus. Wiring layer 408 can include control lines, data lines and power lines. It will be noted that in spite of the beam apertures 406 there is ample space for all necessary connections. The detection module 402 can also be fabricated using bipolar or other manufacturing techniques. A printed circuit board and/or other semiconductor chips may be provided on the backside of detector module 402.

**FIG. 4** depicts a three electrode objective lens but it will be appreciated that any other form of objective lens, e.g. a two electrode lens, may also be used.

Reference is now made to **FIG. 10,** which is a schematic diagram illustrating another exemplary electron beam tool 40a that may be part of the exemplary charged particle beam inspection apparatus 100 of **FIG. 1** in place of the tool 40 of **FIG. 2.** Parts of the apparatus 40a that have similar functions as corresponding parts of the apparatus 40 of **FIG. 2** are identified with the same references. A reduced or simplified description of such parts is included below in some cases.

Multi-beam electron beam tool 40a (also referred to herein as apparatus 40a) comprises an electron source 201, a projection apparatus 230, a motorized stage 209, and a sample holder 207. The electron source 201 and projection apparatus 230 may together be referred to as an illumination apparatus. The sample holder 207 is supported by motorized stage 209 so as to hold a sample 208 (e.g., a substrate or a mask) for inspection. Multi-beam electron beam tool 40a further comprises an electron detection device 1240. (Note this may be different in structure from the electron detection device 240 in the secondary electron-optical column of the embodiments referred in reference with Figures 2 and 3, although it has the same function: to detect electrons from the sample).

Electron source 201 may comprise a cathode (not shown) and an extractor or anode (not shown). During operation, electron source 201 is configured to emit electrons as primary electrons from the cathode. The primary electrons are extracted or accelerated by the extractor and/or the anode to form a primary electron beam 202.

Projection apparatus 230 is configured to convert primary electron beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

Controller 50 of **FIG. 1** may be connected to various parts of electron beam tool 40a such as electron source 201, electron detection device 1240, projection apparatus 230, and motorized stage 209. Controller 50 may perform various image and signal processing functions. Controller 50 may also generate various control signals to govern operations of the charged particle beam inspection apparatus, including the charged particle multi-beam apparatus.

Projection apparatus 230 may be configured to focus sub-beams 211, 212, and 213 onto a sample 208 for inspection and may form three probe spots 221, 222, and 223 on the surface of sample 208. Projection apparatus 230 may be configured to deflect primary sub-beams 211, 212, and 213 to scan probe spots 221, 222, and 223 across individual scanning areas in a section of the surface of sample 208. In response to incidence of primary sub-beams 211, 212, and 213 on probe spots 221, 222, and 223 on sample 208, electrons are generated from the sample 208 which include secondary electrons and backscattered electrons. The secondary electrons typically have electron energy ≤ 50 eV and backscattered electrons typically have electron energy between 50 eV and the landing energy of primary sub-beams 211, 212, and 213.

Electron detection device 1240 is configured to detect secondary electrons and/or backscattered electrons and to generate corresponding signals which are sent to a controller or a signal processing system (not shown), e.g. to construct images of the corresponding scanned areas of sample 208. Electron detection device 1240 may comprise a detector module 402 integrated with an objective lens 401 as described above with reference to **FIGS. 4 to 7.**

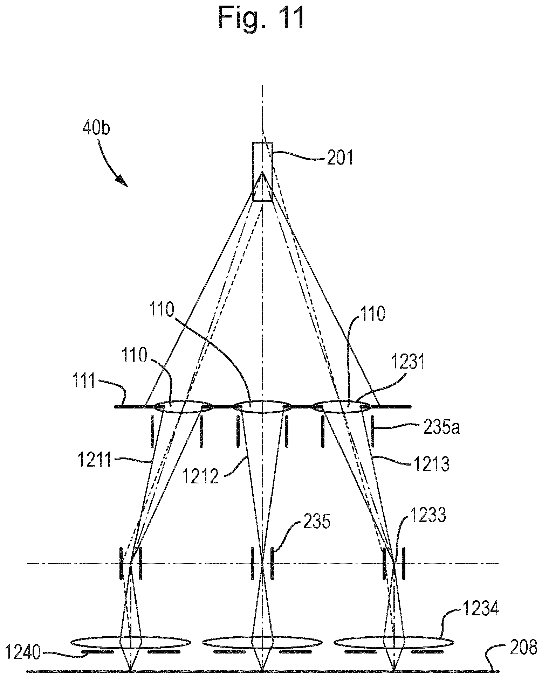

**FIG. 11** is a schematic diagram illustrating another exemplary electron beam tool 40b that may be part of the exemplary charged particle beam inspection apparatus 100 of **FIG. 1** in place of the tool 40 of **FIG. 2.** Parts of the apparatus 40a that have similar functions as corresponding parts of the apparatus 40 of **FIG. 2** are identified with the same references. A reduced or simplified description of such parts is included below in some cases.

Electron source 201 directs electrons toward an array of condenser lenses 1231 forming part of projection system 230. The electron source is desirably a high brightness thermal field emitter with a good compromise between brightness and total emission current. There may be many tens, many hundreds or many thousands of condenser lenses 1231. Condenser lenses 1231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The array of condenser lenses may take the form of at least two plates, acting as electrodes, with an aperture in each plate aligned with each other and corresponding to the location of a sub-beam. At least two of the plates are maintained during operation at different potentials to achieve the desired lensing effect.

In an arrangement the array of condenser lenses is formed of three plate arrays in which charged particles have the same energy as they enter and leave each lens, which arrangement may be referred to as an Einzel lens. The beam energy is the same on entering as leaving the Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

The array of condenser lenses may comprise a plurality of beam apertures 110. The beam apertures 110 may be formed, for example, by openings in a substantially planar beam aperture body 111. The beam apertures 110 divide a beam of charged particles from source 201 into a corresponding plurality of sub-beams. Each condenser lens in the array directs electrons into a respective sub-beam 1211, 1212, 1213 which is focused at a respective intermediate focus 1233. At the intermediate focuses 1233 are deflectors 235. Deflectors 235 are configured to bend a respective sub-beam 1211, 1212, 1213 by an amount effective to ensure that the principal ray (which may also be referred to as the beam axis) is incident on the sample 208 substantially normally (i.e. at substantially 90° to the nominal surface of the sample). Deflectors 235 may also be referred to as collimators. Downbeam (i.e. closer to the sample) of the intermediate focuses 1233 are a plurality of objective lenses 1234, each of which directs a respective sub-beam 1211, 1212, 1213 onto the sample 208. Objective lenses 1234 can be configured to demagnify the electron beam by a factor greater than 10, desirably in the range of 50 to 100 or more.

An electron detection device 1240 is provided between the objective lenses 1234 and the sample 208 to detect secondary and/or backscattered electrons emitted from the sample 208. Electron detection device 1240 may comprise a detector module 402 integrated with an objective lens 401 as described above with reference to **FIGS. 4 to 7.** The electron detection device 1240 may comprise sensor units for example capture electrodes 402.

The system of **FIG. 11** can be configured to control the landing energy of the electrons on the sample. The landing energy can be selected to increase emission and detection of secondary electrons dependent on the nature of the sample being assessed. A controller provided to control the objective lenses 1234 may be configured to control the landing energy to any desired value within a predetermined range or to a desired one of a plurality of predetermined values. In an embodiment, the landing energy can be controlled to desired value in the range of from 1000 eV to 5000 eV. Details of electrode structures and potentials that can be used to control landing energy are disclosed in EPA 20158804.3, which document is incorporated herein by reference.

In some embodiments, the charged particle assessment tool further comprises one or more aberration correctors that reduce one or more aberrations in the sub-beams. In an embodiment, each of at least a subset of the aberration correctors is positioned in, or directly adjacent to, a respective one of the intermediate foci (e.g. in or adjacent to the intermediate image plane). The sub-beams have a smallest sectional area in or near a focal plane such as the intermediate plane. This provides more space for aberration correctors than is available elsewhere, i.e. upbeam (closer to the source) or downbeam (closer to the sample) of the intermediate plane (or than would be available in alternative arrangements that do not have an intermediate image plane).

In an embodiment, aberration correctors positioned in, or directly adjacent to, the intermediate foci (or intermediate image plane) comprise deflectors to correct for the source 201 appearing to be at different positions for different beams. Correctors can be used to correct macroscopic aberrations resulting from the source that prevent a good alignment between each sub-beam and a corresponding objective lens.

The aberration correctors may correct aberrations that prevent a proper column alignment. Such aberrations may also lead to a misalignment between the sub-beams and the correctors. For this reason, it may be desirable to additionally or alternatively position aberration correctors at or near the condenser lenses 1231 (e.g. with each such aberration corrector being integrated with, or directly adjacent to, one or more of the condenser lenses 1231). This is desirable because at or near the condenser lenses 1231 aberrations will not yet have led to a shift of corresponding sub-beams because the condenser lenses 1231 are vertically close or coincident with the beam apertures. A challenge with positioning correctors at or near the condenser lenses 231, however, is that the sub-beams each have relatively large sectional areas and relatively small pitch at this location, relative to locations further downbeam.

In some embodiments, each of at least a subset of the aberration correctors is integrated with, or directly adjacent to, one or more of the objective lenses 1234. In an embodiment, these aberration correctors reduce one or more of the following: field curvature; focus error; and astigmatism. Additionally or alternatively, one or more scanning deflectors (not shown) may be integrated with, or directly adjacent to, one or more of the objective lenses 1234 for scanning the sub-beams 1211, 1212, 1213 over the sample 208. In an embodiment, the scanning deflectors described in US 2010/0276606, which document is hereby incorporated by reference in its entirety, may be used.

The aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference.

In an embodiment the objective lens referred to in earlier embodiments is an array objective lens. Each element in the array is a micro-lens operating a different beam or group of beams in the multi-beam. An electrostatic array objective lens has at least two plates each with a plurality of holes or apertures. The position of each hole in a plate corresponds to the position of a corresponding hole in the other plate. The corresponding holes operate in use on the same beam or group of beams in the multi-beam. A suitable example of a type of lens for each element in the array is a two electrode decelerating lens.

An electron detection device 1240 is provided between the objective lenses 1234 and the sample 208 to detect secondary and/or backscattered electrons emitted from the sample 208. Electron detection device may comprise a detector module 402 integrated with an objective lens 401 as described above with reference to **FIGS. 4 to 7.** The electron detection device 240 may comprise sensor units for example capture electrodes 405.

In an embodiment of the invention, the correctors 235 at the intermediate focuses 1233 are embodied by a slit deflector 300. Slit deflector 300 is an example of a manipulator and may also be referred to as a slit corrector.

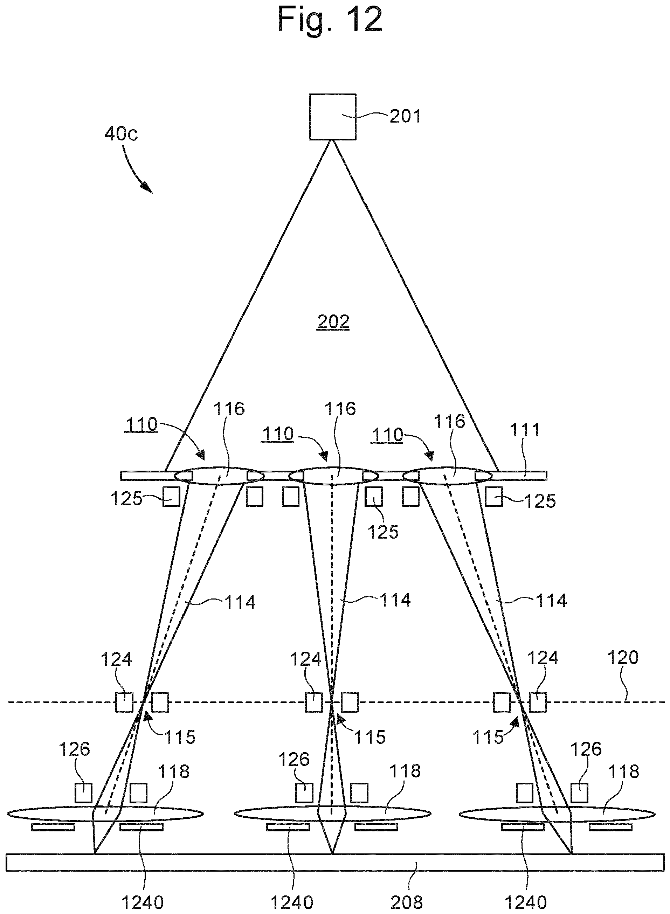

Another exemplary electron beam tool 40c, that may be part of the exemplary charged particle beam inspection apparatus 100 of **FIG. 1** in place of the tool 40 of **FIG. 2,** is illustrated schematically in **FIG. 12.** Parts of the apparatus 40a that have similar functions as corresponding parts of the apparatus 40 of **FIG. 2** are identified with the same references. A reduced or simplified description of such parts is included below in some cases.

The tool 40c further comprises one or more aberration correctors 124, 125, 126 that reduce one or more aberrations in the sub-beams 114. In an embodiment, each of at least a subset of the aberration correctors 124 is positioned in, or directly adjacent to, a respective one of the intermediate foci 115 (e.g. in or adjacent to the intermediate image plane 120). The sub-beams 114 have a smallest cross-sectional area in or near a focal plane such as the intermediate plane 120. This provides more space for aberration correctors 124 than is available elsewhere, i.e. upbeam or downbeam of the intermediate plane 120 (or than would be available in alternative arrangements that do not have an intermediate image plane 120).

In an embodiment, aberration correctors 124 positioned in, or directly adjacent to, the intermediate foci 115 (or intermediate image plane 120) comprise deflectors to correct for the source 201 appearing to be at different positions for different sub-beams 114 derived from beam 112 emitted from source 201. Correctors 124 can be used to correct macroscopic aberrations resulting from the source 201 that prevent a good alignment between each sub-beam 114 and a corresponding objective lens 118.

The aberration correctors 124 may correct aberrations that prevent a proper column alignment. Such aberrations may also lead to a misalignment between the sub-beams 114 and the correctors 124. For this reason, it may be desirable to additionally or alternatively position aberration correctors 125 at or near the condenser lenses 116 (e.g. with each such aberration corrector 125 being integrated with, or directly adjacent to, one or more of the condenser lenses 116). This is desirable because at or near the condenser lenses 116 aberrations will not yet have led to a shift of corresponding sub-beams 114 because the condenser lenses 116 are vertically close or coincident with the beam apertures 110. A challenge with positioning correctors 125 at or near the condenser lenses 116, however, is that the sub-beams 114 each have relatively large cross-sectional areas and relatively small pitch at this location, relative to locations further downstream.

In some embodiments, as exemplified in **FIG. 12,** each of at least a subset of the aberration correctors 126 is integrated with, or directly adjacent to, one or more of the objective lenses 118. In an embodiment, these aberration correctors 126 reduce one or more of the following: field curvature; focus error; and astigmatism. In the apparatus of **FIG. 12,** any or all of the correctors 124, 125, 126 can be slit deflectors.

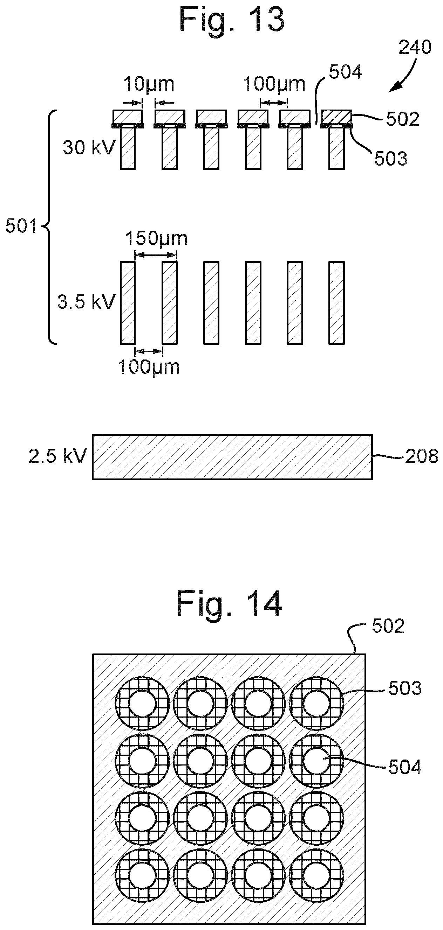

**FIGS. 13 and 14** depict another example of an electron detection device 240 that can be used in an embodiment of the invention, for example it can be incorporated in the electron beam tools 40, 40a, 40b, 40c described above with reference for example to Figures 2, 10, 11 and 12. **FIG. 13** is a schematic side view of electron detection device 240 integrated in or associated with the objective lens array 501 and **FIG. 14** is a view from below of electron detection device 240.

As shown in **FIG. 13,** electron detection device 240 in this example comprises a substrate 502 provided with a plurality of sensor units 503 surrounding respective beam apertures 504. Substrate 502 is mounted to the upper electrode (further from sample 208) of a decelerating array objective lens 501. The sensor units 503 face toward the sample 208. The sensor units may be positioned with the sensing surfaces located between the upbeam and downbeam facing surfaces of the upper electrode. The sensor units 503 may be integrated into or associated with the electrode of the objective lens 501 furthest from the sample 208. This is in contrast to the electron detection device 240 of **FIG. 7** which is integrated into, or associated with, the lower electrode of an array objective lens. (The sensor unit 503 of the Fig. 7 may be mounted to, but not necessarily integrated with an electrode of an array objective lens furthest from the source, or closest to the sample.). **FIG. 13** depicts a two electrode objective lens but it will be appreciated that any other form of objective lens, e.g. a three electrode lens, may also be used.

The electron detection device 240 in this example is placed away from the electrode of the objective lens 501 furthest from the source, in other words away from an upbeam electrode of the objective lens 501. In this position, an electrode in the objective lens 501 is closer to the sample, or down-beam, of the electron detection device 240 . Thus the secondary electrons emitted by the sample 208 are accelerated by down beam positioned electrode array of the objective lens 501, for example to many kV (perhaps about 28.5kV). The substrate supporting the sensor units 503 during operation may be held at the same potential difference as the upper electrode. As a result the sensor units 503 can comprise, for example, PIN detectors and/or scintillators. This has the advantage that no significant additional noise sources are present as PIN detectors and scintillators have a large initial amplification of the signal. Another advantage of this arrangement is that it is easier to access the electron detection device 240, e.g. for making power and signal connections or for servicing in use. Sensor units having capture electrodes could be used at this location instead, but this could result in poorer performance.

A PIN detector comprises a reverse-biased PIN diode and has an intrinsic (very lightly doped) semiconductor region sandwiched between a p-doped and an n-doped region. Secondary electrons incident on the intrinsic semiconductor region generate electron-hole pairs and allow a current to flow, generating a detection signal.

A scintillator comprises a material that emits light when electrons are incident on it. A detection signal is generated by imaging the scintillator with a camera or other imaging device.

In order to correctly image secondary electrodes on the sensor units 503 it is desirable to provide a relatively large potential difference between last electrode and the sample 208. For example the upper electrode of the objective lens may be at about 30 kV, the lower electrode at about 3.5 kV and the sample 208 at about 2.5 kV. A large potential difference between the lower electrode and the sample 208 may increase aberrations of the objective lens on the primary beam but a suitable trade-off can be selected.

Exact dimensions of an embodiment may be determined on a case-by-case basis. The diameter of the beam apertures 504 may be in the range of about 5 to 20 $\mu$m, e.g. about 10$\mu$m. The width of the slits in the electrodes may be in the range of from 50 to 200 $\mu$m, e.g. about 100 $\mu$m. The pitch of the beam apertures and the electrode slits may be in the range of from 100 to 200 $\mu$m, e.g. about 150 $\mu$m. The gap between upper and lower electrodes may be in the range of from about 1 and 1.5 mm, e.g. about 1.2 mm. The depth of the lower electrode may be in the range of from about 0.3 to 0.6 mm, e.g. about 0.48 mm. The working distance between the lower electrode and the sample 208 may be in the range of form about 0.2 to 0.5 mm, e.g. about 0.37 mm. Desirably the electric field strength between the lower electrode and the sample 208 is no more than about 2.7 kV/mm in order to avoid or reduce damage to the sample 208. The field in the gap between upper and lower electrodes can be larger, e.g. over 20 kV/mm

The beam apertures 504 associated with the sensor units have smaller diameters than the electrode arrays to increase the surface of the sensor units available to capture electrodes emanating from the sample. However the dimensions of the beam aperture diameters are selected so that they permit passage of the sub-beams; that is the beam apertures are not beam limiting. The beam apertures are design to permit passage of the sub-beams without shaping their cross-section. The same comment applies to the beam apertures 406 associated with the sensor units 402 of the embodiment depicted in Figures 4 to 7.

In an embodiment, a single sensor unit (e.g. PIN detector) surrounds each aperture. In another embodiment, a plurality of sensor elements (e.g. smaller PIN detectors) is provided around each aperture. The signal generated from electrons captured by sensor elements surrounding one aperture may be combined into a single signal or used to generate independent signals. The sensor elements may be divided radially (i.e. to form a plurality of concentric annuluses), angularly (i.e. to form a plurality of sector-like pieces), both radially and angularly or in any other convenient manner.

An assessment tool according to an embodiment of the invention may be a tool which makes a qualitative assessment of a sample (e.g. pass/fail), one which makes a quantitative measurement (e.g. the size of a feature) of a sample or which generates an image of map of a sample. Examples of assessment tools are inspections tools and metrology tools.

The following are exemplary embodiments of the invention;

> 1. A charged particle assessment tool comprising:
>
>> an objective lens configured to project a plurality of charged particle beams onto a sample, the objective lens having an sample-facing surface defining a plurality of beam 5 apertures through which respective ones of the charged particle beams are emitted toward the sample; and
>> a plurality of capture electrodes adjacent respective ones of the beam apertures and configured to capture charged particles emitted from the sample.
>
> 2. A tool according to embodiment 1 wherein each capture electrode is configured to substantially surround a respective beam aperture.
>
> 3. A tool according to embodiment 1 or 2 wherein the capture electrodes are configured to substantially fill the sample-facing surface.
>
> 4. A tool according to embodiment 1, or 2 wherein the capture electrodes have a circular outer perimeter.
>
> 5. A tool according to anyone of the preceding embodiments further comprising a substrate mounted on the sample-facing surface of the objective lens and on which the capture electrodes are formed.
>
> 6. A tool according to embodiment 5 further comprising control circuitry formed in the substrate.
>
> 7. A tool according to embodiment 6 wherein the control circuitry comprises one or more of:
>
>> •   an amplifier, e.g. a trans-impedance amplifier;
>> •   an analog-to-digital converter;
>> •   a data multiplexor;
>> •   read-out gates.
>
> 8. A tool according to embodiment 7 wherein the control circuitry comprises one amplifier for each capture electrode.
>
> 9. A tool according to any one of embodiments 5 to 8 further comprising conductive traces provided on the other side of the substrate to the capture electrodes.
>
> 10. A tool according to any one of embodiments 5 to 9 further comprising vias passing though the substrate.
>
> 11. A tool according to any one of embodiments 5 to 10 wherein the substrate is formed of silicon
>
> 12. A tool according to any one of the preceding embodiments wherein the capture electrodes are formed by a CMOS process.
>
> 13. A tool according to any one of the preceding embodiments wherein each capture electrode comprises a plurality of electrode elements.
>
> 14. A method of manufacturing an assessment tool, the method comprising:
>
>> forming a plurality of capture electrodes on, and a plurality of apertures in, a substrate; and
>> attaching the substrate to an objective lens configured to project a plurality of charged particle beams onto a sample, so that the charged particle beams can be emitted through the apertures.
>
> 15. A method according to embodiment 14 wherein the apertures are formed by etching through the substrate.
>
> 16. An inspection method comprising:
>
>> emitting a plurality of charged-particle beams through a plurality of beam apertures to a sample; and

capturing charged particles emitted by the sample in response to the charged-particle beams using a plurality of capture electrodes provided adjacent respective ones of the beam apertures.

17. A multi-beam electron-optical system comprising a last electron-optical element in a multi-beam path of the multi-beam electron optical system, the last electron-optical element comprising

- a multi-manipulator array in which each array element is configured to manipulate at least one electron beam in the multi-beam path; and
- a detector configured and orientated to detect electrons emitted from a sample positioned in the multi-beam beam path, wherein the detector comprises a plurality of electrodes integrated into the multi-manipulator array and at least one electrode associated each array element.

18. A last electron-optical element for a multi-charged beam projection system configured to project a plurality of charged particle beams onto a sample, the last electron-optical element comprising:

an objective lens having an sample-facing surface defining a plurality of beam apertures through which respective ones of the charged particle beams are emitted toward the sample; and
a plurality of capture electrodes adjacent respective ones of the beam apertures and configured to capture charged particles emitted from the sample.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses

Clause 1: A charged particle assessment tool comprising: an objective lens configured to project a plurality of charged particle beams onto a sample, the objective lens defining a plurality of beam apertures through which respective ones of the charged particle beams can propagate toward the sample; and a plurality of sensor units adjacent respective ones of the beam apertures and configured to capture charged particles emitted from the sample.
Clause 2: A tool according to clause 1 wherein each sensor unit is configured to substantially surround a respective beam aperture.
Clause 3: A tool according to clause 1, or 2 wherein the sensor units have a circular outer perimeter.
Clause 4: A tool according to anyone of the preceding clauses further comprising a substrate provided at a downbeam-facing surface of the objective lens and on which the sensor units are formed.
Clause 5: A tool according to clause 4 wherein the sensor units are configured to substantially fill the sample-facing surface.
Clause 6: A tool according to clause 4 or 5 wherein the sensor units are capture electrodes.
Clause 7: A tool according to anyone of the preceding clauses further comprising a substrate provided at an upbeam-facing surface of the objective lens and on which the sensor units are formed, preferably the sensor units are configured to face downbeam.
Clause 8: A tool according to clause 7 wherein the sensor units are selected from the group consisting of PIN detectors and scintillators.
Clause 9: A tool according to any one of clauses 4 to 8 further comprising control circuitry formed in the substrate.
Clause 10: A tool according to clause 9 wherein the control circuitry comprises one or more of: an amplifier, e.g. a trans-impedance amplifier; an analog-to-digital converter; a data multiplexor; read-out gates.
Clause 11: A tool according to clause 10 wherein the control circuitry comprises one amplifier for each sensor unit.
Clause 12: A tool according to any one of clauses 4 to 11 further comprising conductive traces provided on the other side of the substrate to the sensor unit.
Clause 13: A tool according to any one of clauses 4 to 12 further comprising vias passing though the substrate.
Clause 14: A tool according to any one of clauses 4 to 13 wherein the substrate is formed of silicon.
Clause 15: A tool according to any one of the preceding clauses wherein the sensor units are formed by a CMOS process.
Clause 16: A tool according to any one of the preceding clauses wherein each sensor unit comprises a plurality of sensor elements.
Clause 17: A method of manufacturing an assessment tool, the method comprising: forming a plurality of sensor units on, and a plurality of apertures in, a substrate; and attaching the substrate to an objective lens configured to project a plurality of charged particle beams onto a sample, so that the charged particle beams can be emitted through the apertures.

Clause 18: A method according to clause 17 wherein the apertures are formed by etching through the substrate.

Clause 19: An inspection method comprising: emitting a plurality of charged-particle beams through a plurality of beam apertures to a sample; and capturing charged particles emitted by the sample in response to the charged-particle beams using a plurality of sensor units provided adjacent respective ones of the beam apertures.

Clause 20: A multi-beam electron-optical system comprising a last electron-optical element in a multi-beam path of the multi-beam electron optical system, the last electron-optical element comprising - a multi-manipulator array in which each array element is configured to manipulate at least one electron beam in the multi-beam path; and - a detector configured and orientated to detect electrons emitted from a sample positioned in the multi-beam beam path, wherein the detector comprises a plurality of sensor units integrated into the multi-manipulator array and at least one sensor unit associated each array element.

Clause 21: A last electron-optical element for a multi-charged beam projection system configured to project a plurality of charged particle beams onto a sample, the last electron-optical element comprising: an objective lens having an sample-facing surface defining a plurality of beam apertures through which respective ones of the charged particle beams can propagate toward the sample; and a plurality of sensor units adjacent respective ones of the beam apertures and configured to capture charged particles emitted from the sample..

The descriptions above are intended to be illustrative, not limiting. Thus, it will be apparent to one skilled in the art that modifications may be made as described without departing from the scope of the claims set out below.

**Claims**

1. A charged particle assessment tool comprising:

    an objective lens configured to project a plurality of charged particle beams onto a sample, the objective lens defining a plurality of beam apertures through which respective ones of the charged particle beams can propagate toward the sample; and
    a plurality of sensor units adjacent respective ones of the beam apertures and configured to capture charged particles emitted from the sample.

2. A tool according to claim 1 wherein each sensor unit is configured to substantially surround a respective beam aperture.

3. A tool according to claim 1, or 2 wherein the sensor units have a circular outer perimeter.

4. A tool according to anyone of the preceding claims further comprising a substrate provided at a downbeam-facing surface of the objective lens and on which the sensor units are formed.

5. A tool according to claim 4 wherein the sensor units are configured to substantially fill the sample-facing surface.

6. A tool according to claim 4 or 5 wherein the sensor units are capture electrodes.

7. A tool according to anyone of the preceding claims further comprising a substrate provided at an upbeam-facing surface of the objective lens and on which the sensor units are formed, preferably the sensor units are configured to face downbeam.

8. A tool according to claim 7 wherein the sensor units are selected from the group consisting of PIN detectors and scintillators.

9. A tool according to any one of claims 4 to 8 further comprising control circuitry formed in the substrate.

10. A tool according to claim 9 wherein the control circuitry comprises one or more of:

    • an amplifier, e.g. a trans-impedance amplifier;
    • an analog-to-digital converter;
    • a data multiplexor;
    • read-out gates.

11. A tool according to any one of claims 4 to 10 further comprising conductive traces provided on the other side of the substrate to the sensor unit.

12. A tool according to any one of claims 4 to 11 further comprising vias passing though the substrate.

13. A tool according to any one of the preceding claims wherein the sensor units are formed by a CMOS process.

14. A tool according to any one of the preceding claims wherein each sensor unit comprises a plurality of sensor elements.

15. An inspection method comprising:

emitting a plurality of charged-particle beams through a plurality of beam apertures to a sample; and
capturing charged particles emitted by the sample in response to the charged-particle beams using a plurality of sensor units provided adjacent respective ones of the beam apertures.

# Fig. 1

# Fig. 2

# Fig. 3

# Fig. 4

100µm      50µm

401

5 kV

few kV

402

5 kV– 10 to 100V

208

5 kV

406

# Fig. 5

402

404

405

406

# Fig. 6

406

# Fig. 7

408

409

404

407

406

405

# Fig. 8

$R_f$

$I_{in}$

$V_{out}$

# Fig. 9

$\overline{i_n^2}$

$R_f$

$\overline{V_{n,\,out}^2}$

# Fig. 10

40a

201

202

230

1240

211, 212, 213

208

207

209

221, 222, 223

Fig. 11

# Fig. 12

# Fig. 13

240

10μm    100μm    504

30 kV
502
503

501

150μm

3.5 kV

100μm

2.5 kV    208

# Fig. 14

502

503

504

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2003/189180 A1 (HAMAGUCHI SHINICHI [JP] ET AL) 9 October 2003 (2003-10-09) * paragraphs [0077] - [0084], [0183] - [0190], [0196], [0199], [0238] - [0239]; figures 1, 29-33,41 * ----- | 1-6,14, 15 | INV. H01J37/04 H01J37/073 H01J37/075 H01J37/244 H01J37/28 |
| X | EP 1 619 495 A1 (TNO [NL]) 25 January 2006 (2006-01-25) * paragraphs [0023] - [0032]; figure 1 * ----- | 7 | |

TECHNICAL FIELDS
SEARCHED      (IPC)

H01J

~~The present search report has been drawn up for all claims~~

| Place of search | Date of completion of the search | Examiner |
|---|---|---|
| Munich | 9 December 2020 | Chevrier, Dominique |

EPO FORM 1503 03.82 (P04C01)

Europäisches
Patentamt

European
Patent Office

Office européen
des brevets

Application Number

EP 20 18 4160

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-7, 14, 15

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

## LACK OF UNITY OF INVENTION
## SHEET B

Application Number

EP 20 18 4160

The Search Division considers that the present European patent application does not comply with the requirements of unity of invention and relates to several inventions or groups of inventions, namely:

1. claims: 1-7, 14, 15

   A charged particle assessment tool and a corresponding inspection method.
   The tool comprising : an objective lens having a plurality of apertures and projecting a plurality of charged particle beams onto a sample;
   a plurality of sensor units formed on a substrate, the sensor units having a plurality of sensor elements surrounding a respective beam aperture and facing the sample surface;
   the substrate on which the sensor units are formed is provided at an upbeam-facing surface of the objective lens.
   ---

2. claims: 8, 13

   A charged particle assessment tool having different types of sensor units.
   ---

3. claims: 9-12

   A charged particle assessment tool having a particular circuitry formed on or in the substrate.
   ---

## ANNEX TO THE EUROPEAN SEARCH REPORT
## ON EUROPEAN PATENT APPLICATION NO.

EP 20 18 4160

This annex lists the patent family members relating to the patent documents cited in the above-mentioned European search report.
The members are as contained in the European Patent Office EDP file on
The European Patent Office is in no way liable for these particulars which are merely given for the purpose of information.

09-12-2020

| Patent document cited in search report | | | Publication date | Patent family member(s) | | | Publication date |
|---|---|---|---|---|---|---|---|
| US 2003189180 | A1 | | 09-10-2003 | JP | 4451042 | B2 | 14-04-2010 |
| | | | | KR | 20030028461 | A | 08-04-2003 |
| | | | | TW | 492069 | B | 21-06-2002 |
| | | | | US | 2003189180 | A1 | 09-10-2003 |
| | | | | WO | 0175951 | A1 | 11-10-2001 |
| EP 1619495 | A1 | | 25-01-2006 | CN | 101023342 | A | 22-08-2007 |
| | | | | EP | 1619495 | A1 | 25-01-2006 |
| | | | | EP | 1779097 | A2 | 02-05-2007 |
| | | | | IL | 180835 | A | 30-06-2015 |
| | | | | JP | 5179176 | B2 | 10-04-2013 |
| | | | | JP | 2008507690 | A | 13-03-2008 |
| | | | | KR | 20070085210 | A | 27-08-2007 |
| | | | | US | 2007272856 | A1 | 29-11-2007 |
| | | | | WO | 2006009444 | A2 | 26-01-2006 |

EPO FORM P0459

For more details about this annex : see Official Journal of the European Patent Office, No. 12/82

## REFERENCES CITED IN THE DESCRIPTION

**Patent documents cited in the description**

- EP 1602121 A1
- US 20100276606 A
- EP 2702595 A1
- EP 2715768 A2